# EUROPÄISCHE PATENTSCHRIFT

(11) **EP 3 791 123 B1**
(45) Veröffentlichungstag und Bekanntmachung des Hinweises auf die Patenterteilung: **09.02.2022**
(21) Anmeldenummer: 20739296.0
(22) Anmeldetag: 02.07.2020
(51) Int. Cl.: F28D 1/02, F28D 1/04, F28F 27/00, F25B 25/00, F25B 41/00, F25D 17/02, H05K 7/20

(54) **KÜHLSYSTEM SOWIE VERFAHREN ZUM TEMPERIEREN EINES RECHENZENTRUMS UNTER NUTZUNG EINES KÜHLSYSTEMS**
COOLING SYSTEM AND METHOD FOR THE TEMPERATURE CONTROL OF A COMPUTING CENTER BY MEANS OF A COOLING SYSTEM
SYSTÈME DE REFROIDISSEMENT ET PROCÉDÉ POUR THERMORÉGULER UN CENTRE INFORMATIQUE EN UTILISANT UN SYSTÈME DE REFROIDISSEMENT

(30) Priorität: 17.07.2019 DE 102019119358
(43) Veröffentlichungstag der Anmeldung: 17.03.2021
(73) Patentinhaber: Cabero Beteiligungs-GmbH, 86899 Landsberg (DE)
(72) Erfinder: UGI, Martin, 76307 Karlsbad (DE)
(74) Vertreter: Grättinger Möhring von Poschinger Patentanwälte Partnerschaft mbB
(86) Internationale Anmeldenummer: PCT/EP2020/068669
(87) Internationale Veröffentlichungsnummer: WO 2021/008888

(56) Entgegenhaltungen:
- DE-A1- 19 502 153
- DE-A1-102010 049 134
- DE-A1-102015 221 347
- DE-U1-202016 105 392
- DE-U1-202019 102 229
- US-A1- 2012 297 807

## Beschreibung

Die vorliegende Erfindung betrifft ein Verfahren zum Temperieren eines Rechenzentrums unter Nutzung eines Kühlsystems sowie ein in einem solchen Verfahren nutzbares Kühlsystem. Das Kühlsystem umfasst dabei einen dem Rechenzentrum Wärme entziehenden, in einen Kühlmittel-Primärkreis eingebetteten Primär-Wärmetauscher und einen Wärme an die Umgebung abgebenden, als Kühlmittel-Luft-Wärmetauscher ausgeführten, in einen Kühlmittel-Sekundärkreis eingebetteten Sekundär-Wärmetauscher, welcher ein Gehäuse, ein Gebläse und zwei V-förmig angeordnete Kühlregister aufweist. Zwischen den Kühlmittel-Primärkreis und den Kühlmittel-Sekundärkreis ist ein einen Kältemittel-Verdichter und eine Kältemittel-Expansionseinheit aufweisender Kompressionskältemaschinenkreis schaltbar. In einem ersten Betriebsmodus erfolgt ein Wärmetransport vom Kühlmittel-Primärkreis auf den Kühlmittel-Sekundärkreis unter Zwischenschaltung des Kompressionskältemaschinenkreises, und in einem zweiten Betriebsmodus erfolgt ein Wärmetransport vom Kühlmittel-Primärkreis auf den Kühlmittel-Sekundärkreis ohne Zwischenschaltung des Kompressionskältemaschinenkreises.

Unter einem Rechenzentrum wird im Zusammenhang mit dieser Erfindung eine Räumlichkeit bezeichnet, in der die zentrale computerbasierte Rechentechnik einer Organisation untergebracht ist. Da beim Betrieb eines Rechenzentrums in erheblichem Umfang Abwärme entsteht und der bestimmungsgemäße Betrieb eines Rechenzentrums nur dann erfolgen kann, wenn definierte Temperaturvorgaben innerhalb der Räumlichkeit des Rechenzentrums eingehalten werden, werden Rechenzentren typischerweise mit Hilfe von Kühlsystemen temperiert, indem die Abwärme an die Umgebung abgeführt wird.

Eine besondere Herausforderung bei der Temperierung von Rechenzentren besteht dabei darin, über den gesamten, sehr breiten Betriebsbereich des jeweiligen Rechenzentrums, der abhängig von der Auslastung des Rechenzentrums sowie der aktuellen Wettersituation von geringen abzuführenden Wärmemengen bei niedriger Außentemperatur bis hin zu sehr großen abzuführenden Wärmemengen bei hohen Außentemperaturen reichen kann, einen hocheffizienten, hochverlässlichen sowie kostengünstigen Betrieb zu gewährleisten. Das eingangs beschriebene, gattungsgemäße Verfahren zum Temperieren eines Rechenzentrums unter Nutzung eines Kühlsystems ist dabei aus dem Stand der Technik bekannt. Auf der Veranstaltung infrakon am 18. Februar 2016 beschrieb JAEGGI Hybridtechnologie AG - vgl. http://www.infrakon.de/media/Download%20Staffel%2020/InfraKon% 20Praesentation%20JAEGGI.pdf - beispielsweise ein Verfahren zur Rückkühlung von Rechenzentren, bei dem ein Kühlsystem zum Einsatz kommt, welches Abwärme entweder im Modus "Kältemaschinen-Kühlung" unter Einsatz der Kältemaschine (was dem ersten Betriebsmodus entspricht) oder aber - unter deren Umgehung - im Modus "Freie Kühlung" (was dem zweiten Betriebsmodus entspricht) an die Umgebung abführt. Die Temperierung des Rechenzentrums im zweiten Betriebsmodus ("Freie Kühlung"), also ohne Zwischenschaltung des Kompressionskältemaschinenkreises, ist dabei energieeffizienter und somit kostengünstiger, da auf den Betrieb des Kältemittel-Verdichters verzichtet und somit Energie eingespart werden kann, wobei überdies die im ersten Betriebsmodus zum Betrieb des Kältemittel-Verdichters erforderliche Energie zusätzlich über den Sekundär-Wärmetauscher aus dem System auszuschleusen ist und insoweit auch noch mittelbar die Effizienz beeinträchtigt. Der energiesparende zweite Betriebsmodus ist allerdings nur in einem gewissen Betriebsbereich möglich, wenn gewisse abzuführende Abwärmemengen nicht überschritten werden und gewisse Umgebungsbedingungen (z. B. Temperatur, Feuchtigkeit) gegeben sind.

Die DE 10 2015 221 347 A1 offenbart ein ähnliches Verfahren und System zur Temperierung eines Rechenzentrums.

Der Erfindung liegt die Aufgabe zugrunde, ein gegenüber dem Stand der Technik hinsichtlich der Energieeffizienz, der Zuverlässigkeit bzw. Verfügbarkeit, des Ressourcenverbrauchs sowie der Kosten verbessertes Verfahren zur Temperierung eines Rechenzentrums der eingangs genannten Art sowie ein hierzu nutzbares Kühlsystem bereitzustellen.

Diese Aufgabe wird erfindungsgemäß, in überraschend einfacher Weise, durch das in Anspruch 1 angegebene Verfahren zur Temperierung eines Rechenzentrums und durch das Kühlsystem nach Anspruch 6 gelöst.

Das erfindungsgemäße Verfahren zur Temperierung nutzt somit ein Kühlsystem, welches einen dem Rechenzentrum Wärme entziehenden Primär-Wärmetauscher und einen Wärme an die Umgebung abgebenden, als Kühlmittel-Luft-Wärmetauscher ausgeführten Sekundär-Wärmetauscher umfasst, welcher ein Gehäuse, ein Gebläse und zwei V-förmig angeordnete Kühlregister aufweist. Der Primär-Wärmetauscher ist in einen Kühlmittel-Primärkreis und der Sekundär-Wärmetauscher ist in einen Kühlmittel-Sekundärkreis eingebettet, zwischen welche ein einen Kältemittel-Verdichter und eine Kältemittel-Expansionseinheit aufweisender Kompressionskältemaschinenkreis schaltbar ist. In einem ersten Betriebsmodus erfolgt ein Wärmetransport vom Kühlmittel-Primärkreis auf den Kühlmittel-Sekundärkreis unter Zwischenschaltung des Kompressionskältemaschinenkreises, und in einem zweiten Betriebsmodus erfolgt ein Wärmetransport vom Kühlmittel-Primärkreis auf den Kühlmittel-Sekundärkreis ohne Zwischenschaltung des Kompressionskältemaschinenkreises, wobei die Kühlregister des Sekundär-Wärmetauschers in dem ersten Betriebsmodus in Parallelschaltung, im zweiten Betriebsmodus hingegen in Reihenschaltung durchströmt sind.

Die Umschaltbarkeit der zwei Kühlregister innerhalb des (ein Gehäuse, ein Gebläse und zwei V-förmig angeordnete Kühlregister umfassenden) Sekundär-Wärmetauschers zwischen Parallelschaltung im ersten Betriebsmodus und Reihenschaltung im zweiten Betriebsmodus ermöglicht dabei nicht nur eine gegenüber dem Stand der Technik völlig neuartige Betriebs-Flexibilität, indem sich eine bisher nicht gekannte, sich in vorteilhafter Weise in einer Erhöhung der Energieeffizienz und somit einer Reduktion von Energiebedarf und Betriebskosten niederschlagende Anpassbarkeit des Kühlsystems an die vorherrschenden Betriebsbedingungen erreichen lässt. Vielmehr nutzt die vorliegende Erfindung eine Erkenntnis, die dem zu Erwartenden genau zuwider läuft. Denn im Falle der Reihenschaltung zweier Kühlregister durchströmt das Kühlmittel bei einem vorgegebenen Volumenstrom diese mit einer höheren Durchflussgeschwindigkeit als im Falle der Parallelschaltung. Mit der höheren Durchflussgeschwindigkeit gehen höhere Druck- und Reibungsverluste einher, was sich beides in einem erhöhten Pumpenstrombedarf für die Förderung des Kühlmittels niederschlägt und somit zu einem an sich unerwünschten zusätzlichen Energieeintrag führt und zudem mit nachteilig höheren Energiekosten zu Buche schlägt. Dass die vorliegende Erfindung gleichwohl genau diesen Weg beschreitet, basiert auf der (überraschenden) Erkenntnis, dass die dargelegten negativen Effekte in unerwarteter Weise dadurch (über-)kompensiert werden, dass sich bedingt durch die höhere Durchflussgeschwindigkeit in den Rohren der Kühlregister eine turbulente Grenzschichtströmung ausbilden kann, die im Vergleich mit der sich bei in Reihenschaltung durchströmten Kühlregistern gewöhnlich ausbildenden laminaren Grenzschichtströmung mit einem deutlich höheren Wärmeübergangskoeffizient einher geht. Dieser deutlich höhere Wärmeübergangskoeffizient ermöglicht nun zweierlei: Bei gleichbleibender abzuführenden Abwärmemenge kann der Volumenstrom des Kühlmittels reduziert werden, wodurch Pumpenergie eingespart werden kann; bei gleichbleibendem Volumenstrom kann mehr Abwärme abgeführt werden, was ermöglicht, dass der besonders energieeffiziente zweite Betriebsmodus (unter Umgehung des

Kompressionskältemaschinenkreis) in einem breiteren Betriebsbereich genutzt werden kann und somit nur in einem schmalen Betriebsbereich auf den ersten Betriebsmodus zurückgegriffen werden muss. Beides ist der Energieeffizienz des erfindungsgemäßen Verfahrens zuträglich, was sich in geringeren Betriebskosten sowie geringerem Ressourcenbedarf niederschlagen kann.

Gemäß einer ersten bevorzugten Weiterbildung der Erfindung ist das Verfahren zum Temperieren eines Rechenzentrums dadurch gekennzeichnet, dass im zweiten Betriebsmodus der Kühlmittel-Primärkreis und der Kühlmittel-Sekundärkreis mittels schaltbarer Verbindungsleitungen hydraulisch miteinander verbunden sind. Durch diese direkte hydraulische Verbindung von Kühlmittel-Primärkreis und Kühlmittel-Sekundärkreis kann auf die Zwischenschaltung eines Wärmetauschers verzichtet werden, wodurch die mit einem Wärmetauscher einhergehenden Grädigkeitsverluste vermieden und somit ein niedrigeres unteres Temperaturniveau im Kühlmittel-Primärkreislauf erzielt werden kann, was sich in einer höheren Energieeffizienz, geringerem Energiebedarf und geringeren Betriebskosten niederschlagen kann.

Bedingt durch spezifische technische, sicherheitstechnische sowie klimatische Anforderungen kann es gemäß einer anderen Weiterbildung des erfindungsgemäßen Verfahrens allerdings vorteilhaft sein, wenn im zweiten Betriebsmodus der Kühlmittel-Primärkreis und der Kühlmittel-Sekundärkreis über einen als Kühlmittel-Kühlmittel-Wärmetauscher ausgebildeten Koppel-Wärmetauscher gekoppelt sind. Dies ist insbesondere dann der Fall, wenn - bedingt durch die obig genannten Anforderungen - der Einsatz unterschiedlicher Kühlmittel im Kühlmittel-Primärkreis und im Kühlmittel-Sekundärkreis vorteilhaft oder eine hydraulische Entkoppelung aus anderen, insbesondere sicherheitstechnischen Gründen angezeigt ist. Eine besonders kompakte und robuste Einheit lässt sich realisieren, wenn - gemäß einer anderen Weiterbildung des erfindungsgemäßen Verfahrens zum Temperieren eines Rechenzentrums - das Umschalten zwischen Parallelschaltung und Reihenschaltung der Kühlregister des Sekundär-Wärmetauschers mittels einer Ventil-Leitungseinheit erfolgt, die innerhalb des Sekundär-Wärmetauschers untergebracht ist.

Eine wiederum andere bevorzugte Weiterbildung des erfindungsgemäßen Verfahrens zeichnet sich dadurch aus, dass die Auswahl eines Betriebsmodus' durch den Abgleich eines oder mehrerer Mess- und/oder Sollwerte mit entsprechenden, in einer Steuerung hinterlegten Kennfeldern erfolgt. Auf diese Weise kann erreicht werden, dass das Verfahren zum Temperieren des Rechenzentrums stets in demjenigen Betriebsmodus betrieben wird, der sich in Anbetracht der aktuellen Betriebsbedingungen als der vorteilhafteste auszeichnet, wodurch die Energieeffizienz des Verfahrens erhöht werden kann.

Die vorliegende Erfindung umfasst neben dem weiter oben ausgeführten Verfahren zur Temperierung eines Rechenzentrums, wie bereits erwähnt, auch ein hierfür geeignetes Kühlsystem.

Das erfindungsgemäße, zum Temperieren eines Rechenzentrums geeignete Kühlsystem umfasst einen Wärme einschleusenden Primär-Wärmetauscher und einen Wärme ausschleusenden, als Kühlmittel-Luft-Wärmetauscher ausgeführten Sekundär-Wärmetauscher, welcher ein Gehäuse, ein Gebläse und zwei V-förmig angeordnete Kühlregister aufweist. Der Primär-Wärmetauscher ist in einen Kühlmittel-Primärkreis und der Sekundär-Wärmetauscher ist in einen Kühlmittel-Sekundärkreis eingebettet, zwischen welche ein einen Kältemittel-Verdichter und eine Kältemittel-Expansionseinheit aufweisender Kompressionskältemaschinenkreis schaltbar ist. Das Kühlsystem ist in einem ersten Betriebsmodus, in dem ein Wärmetransport vom Kühlmittel-Primärkreis auf den Kühlmittel-Sekundärkreis unter Zwischenschaltung des Kompressionskältemaschinenkreises erfolgt, und in einem zweiten Betriebsmodus, in dem ein Wärmetransport vom Kühlmittel-Primärkreis auf den Kühlmittel-Sekundärkreis ohne Zwischenschaltung des Kompressionskältemaschinenkreises erfolgt, betreibbar. Die Kühlregister des Sekundär-Wärmetauschers sind in dem ersten Betriebsmodus in Parallelschaltung, im zweiten Betriebsmodus hingegen in Reihenschaltung durchströmbar.

Die vorstehend im Zusammenhang mit dem korrespondierenden erfindungsgemäßen Verfahren ausgeführten Vorteile treffen dabei auch auf das oben beschriebene erfindungsgemäße Kühlsystem mitsamt dessen im Folgenden ausgeführten bevorzugten Weiterentwicklungen zu. Im Sinne der Vermeidung von Wiederholungen wird daher auf eine erneute Ausführung der Vorteile im Zusammenhang mit dem erfindungsgemäßen Kühlsystem verzichtet.

Gemäß einer bevorzugten Weiterbildung des erfindungsgemäßen Kühlsystems sind im zweiten Betriebsmodus der Kühlmittel-Primärkreis und der Kühlmittel-Sekundärkreis mittels schaltbarer Verbindungsleitungen hydraulisch miteinander verbunden. Eine andere, sich für bestimmte Anwendungsfälle als besonders vorteilhaft erweisende Weiterbildung des erfinderischen Kühlsystems ist demgegenüber dadurch gekennzeichnet, dass im zweiten Betriebsmodus der Kühlmittel-Primärkreis und der Kühlmittel-Sekundärkreis über einen als Kühlmittel-Kühlmittel-Wärmetauscher ausgebildeten Koppel-Wärmetauscher gekoppelt sind.

Eine äußerst kompakte und robuste Weiterbildung des Kühlsystems ist dadurch gekennzeichnet, dass das Umschalten zwischen Parallelschaltung und Reihenschaltung der Kühlregister des Sekundär-Wärmetauschers mittels einer Ventil-Leitungseinheit erfolgt, die innerhalb des Sekundär-Wärmetauschers untergebracht ist.

Gemäß einer anderen Weiterbildung des erfindungsgemäßen Kühlsystems erfolgt die Auswahl eines Betriebsmodus durch den Abgleich eines oder mehrerer Mess- und/oder Sollwerte mit entsprechenden, in einer Steuerung hinterlegten Kennfeldern.

Um Missverständnissen vorzubeugen ist vorsorglich auf zwei Gesichtspunkte hinzuweisen wie folgt: Die Formulierungen "ein Gebläse", "zwei Kühlregister" etc. sind nicht als die jeweilige Anzahl limitierende Angaben zu verstehen; so lässt sich die Erfindung beispielsweise auch im Zusammenhang mit einem vier Kühlregister und zwei Gebläse aufweisenden Sekundär-Wärmetauscher realisieren. Eine 1:1-Koppelung der Umschaltung der Durchströmung des Sekundär-Wärmetauschers mit dem Betriebsmodus des Kühlsystems ist zwar möglich und ggf. sinnvoll, sie ist aber keineswegs zwingend; vielmehr ist nur notwendig, dass die Kühlregister des Sekundär-Wärmetauschers im ersten Betriebsmodus des Kühlsystems jedenfalls auch in Parallelschaltung und im zweiten Betriebsmodus des Kühlsystems jedenfalls auch in Reihenschaltung durchströmbar sind.

Im Folgenden wird die Erfindung anhand mehrerer verschiedener in den (schematischen) Zeichnungen veranschaulichter Ausführungsbeispiele näher erläutert. Dabei zeigt
- Fig. 1: ein erstes Ausführungsbeispiel eines erfindungsgemäßen Kühlsystems,
- Fig. 2: ein zweites Ausführungsbeispiel eines erfindungsgemäßen Kühlsystems,
- Fig. 3: einen bei den Kühlsystemen nach Figuren 1 und 2 einsetzbaren Sekundär-Wärmetauscher im ersten Betriebsmodus des betreffenden Kühlsystems und
- Fig. 4: den Sekundär-Wärmetauscher nach Fig. 3 im zweiten Betriebsmodus des betreffenden Kühlsystems.

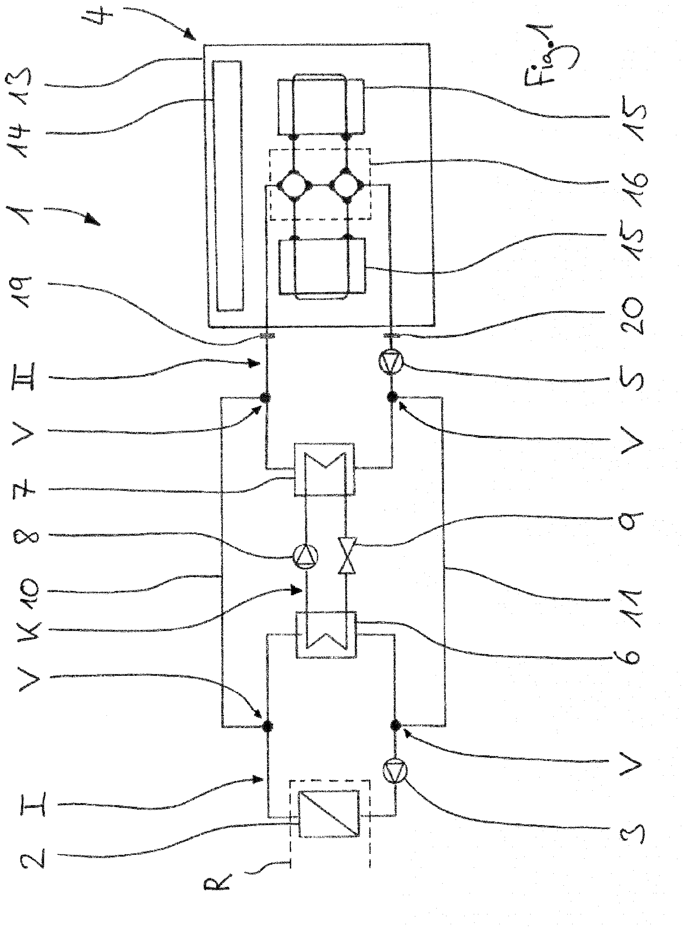

Das in Fig. 1 dargestellte, zum Temperieren eines Rechenzentrums R geeignete Kühlsystem 1 umfasst einen Kühlmittel-Primärkreis I und einen Kühlmittel-Sekundärkreis II. Der Kühlmittel-Primärkreis I umfasst einen - der Atmosphäre des Rechenzentrums R ausgesetzten - Wärme in ihn einschleusenden Primär-Wärmetauscher 2 und eine Primär-Kühlmittelpumpe 3; und der Kühlmittel-Sekundärkreis II umfasst einen - der Umgebung ausgesetzten - Wärme aus ihm ausschleusenden, als Kühlmittel-Luft-Wärmetauscher ausgeführten Sekundär-Wärmetauscher 4 und eine Sekundär-Kühlmittelpumpe 5.

Zwischen dem Kühlmittel-Primärkreis I und dem Kühlmittel-Sekundärkreis II ist ein diese thermisch miteinander koppelnder Kompressionskältemaschinenkreis K angeordnet. Dieser weist einen primärseitigen ersten Wärmetauscher 6, einen sekundärseitigen zweiten Wärmetauscher 7, einen Kältemittel-Verdichter 8 und eine Kältemittel-Expansionseinheit 9 auf. Weiterhin sind der Kühlmittel-Primärkreis I und dem Kühlmittel-Sekundärkreis II über Verbindungsleitungen 10 und 11 hydraulisch miteinander koppelbar. Zur Umschaltung zwischen der hydraulisch entkoppelten thermischen Koppelung des Kühlmittel-Primärkreises I und des Kühlmittel-Sekundärkreises II miteinander über den Kompressionskältemaschinenkreis K einerseits und der hydraulischen Koppelung des Kühlmittel-Primärkreises I und des Kühlmittel-Sekundärkreises II miteinander über die beiden Verbindungsleitungen 10 und 11 andererseits dienen Umsteuerventile V.

In einem ersten Betriebsmodus erfolgt ein Wärmetransport vom Kühlmittel-Primärkreis I auf den Kühlmittel-Sekundärkreis II unter Zwischenschaltung des Kompressionskältemaschinenkreises K. In einem zweiten Betriebsmodus erfolgt ein Wärmetransport vom Kühlmittel-Primärkreis I auf den Kühlmittel-Sekundärkreis II ohne Zwischenschaltung, d. h. unter Umgehung des Kompressionskältemaschinenkreises K. Hierzu sind, wie in Fig. 1 dargestellt, der Kühlmittel-Primärkreis I und der Kühlmittel-Sekundärkreis II über die Verbindungsleitungen 10 und 11 hydraulisch miteinander verbunden.

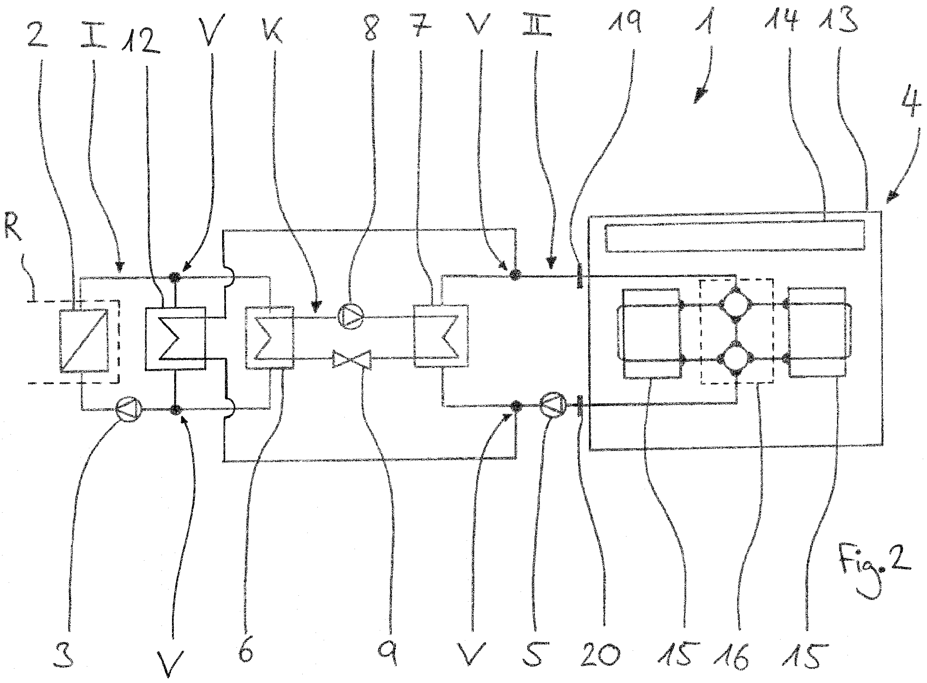

In alternativer Ausgestaltung kann das Kühlsystem 1, wie dies in Fig. 2 veranschaulicht ist, statt der nach Fig. 1 vorgesehenen hydraulischen Koppelung des Kühlmittel-Primärkreises I und des Kühlmittel-Sekundärkreises II miteinander über die Verbindungsleitungen 10 und 11 eine - ebenfalls den Kompressionskältemaschinenkreis K umgehende - hydraulisch entkoppelte thermische Koppelung des Kühlmittel-Primärkreises I und des Kühlmittel-Sekundärkreises II miteinander über einen Koppel-Wärmetauscher 12, welcher als Kühlmittel-Kühlmittel-Wärmetauscher ausgebildet ist, aufweisen. Der Koppel-Wärmetauscher 12 ist dabei über die Umsteuerventile V primärseitig in den Kühlmittel-Primärkreis I und sekundärseitig in den (erweiterten) Kühlmittel-Sekundärkreis II einschaltbar.

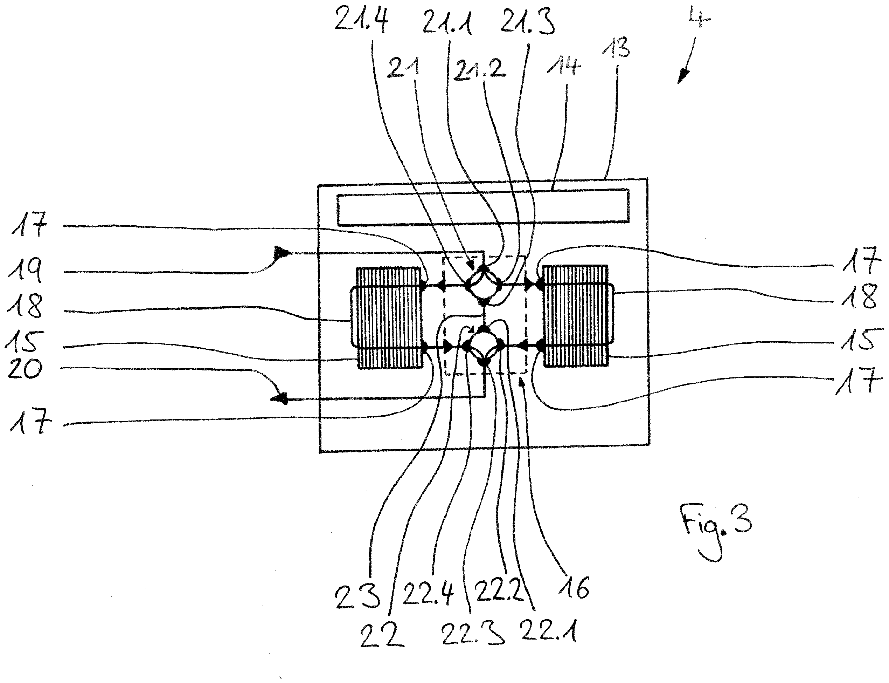

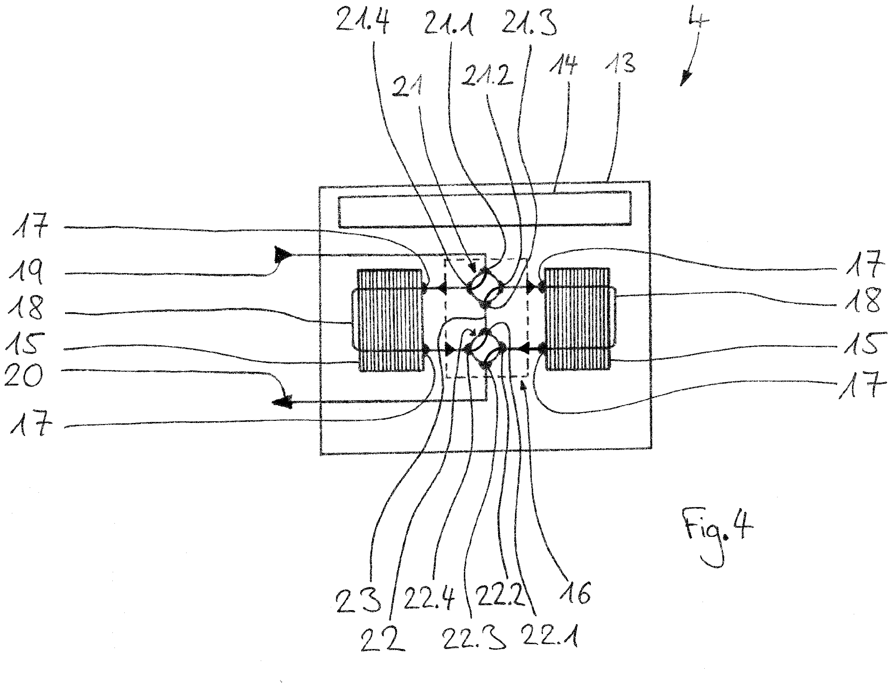

Bei beiden vorstehend erläuterten Ausgestaltungen umfasst der Sekundär-Wärmetauscher 4, wie in den Figuren 3 und 4 gezeigt, jeweils ein Gehäuse 13, ein (ggf. mehrere Ventilatoren aufweisendes) Gebläse 14, zwei Kühlregister 15 sowie eine Ventil-Leitungseinheit 16. Die beiden Kühlregister 15 sind als Zweipass-Wärmetauscher ausgeführt, so dass sich jeweils an dem einen der beiden Enden die beiden Anschlüsse 17 und an dem gegenüberliegenden Ende eine Umlenkeinheit 18 befinden. Sie sind dabei innerhalb des Gehäuses V-förmig zueinander - mit dem Gebläse 14 oberhalb der Kühlregister 15 zwischen diesen - angeordnet verbaut dergestalt, dass sich die vier Anschlüsse 17 der beiden Kühlregister 15 auf derselben Seite befinden. Hier sind die Anschlüsse 17 der beiden Kühlregister 15 an die - innerhalb des Gehäuses 13 untergebrachte - Ventil-Leitungseinheit 16 angeschlossen, in welche auch der Vorlauf 19 und der Rücklauf 20 des Sekundär-Wärmetauschers 4 integriert sind.

Mittels der Ventil-Leitungseinheit 16 erfolgt, wie dem Vergleich der Figuren 3 und 4 zu entnehmen ist, das Umschalten zwischen Parallelschaltung und Reihenschaltung der beiden Kühlregister 15 des Sekundär-Wärmetauschers 4. Sie sind in dem ersten Betriebsmodus des Kühlsystems in Parallelschaltung, im zweiten Betriebsmodus hingegen in Reihenschaltung durchströmbar.

Die Ventil-Leitungseinheit 16 umfasst in der in Fig. 3 und Fig. 4 dargestellten Ausführungsform ein erstes Umschaltventil 21 und ein zweites Umschaltventil 22, wobei beide Umschaltventile 21, 22 jeweils vier Anschlüsse, nämlich einen ersten Anschluss 21.1, 22.1, einen zweiten Anschluss 21.2, 22.2, einen dritten Anschluss 21.3, 22.3 sowie einen vierten Anschluss 21.4, 22.4, aufweisen. Der dritte Anschluss 21.3 des ersten Umschaltventils 21 ist dabei mit dem ersten Anschluss 22.1 des zweiten Umschaltventils 22 mittels einer Ventilverbindungsleitung 23 verbunden.

Im ersten Betriebsmodus, wenn die Kühlregister 15 in Parallelschaltung durchströmbar sind, sind die beiden Umschaltventile 21, 22 derart geschaltet,
- dass im ersten Umschaltventil 21 dessen erster Anschluss 21.1 mit dessen zweitem Anschluss 21.2 und dessen viertem Anschluss 21.4 hydraulisch verbunden ist und
- dass im zweiten Umschaltventil 22 dessen dritter Anschluss 22.3 mit dessen zweitem Anschluss 22.2 und dessen viertem Anschluss 22.4 hydraulisch verbunden ist.

Dadurch wird der Kühlmittelstrom so gelenkt, dass er vom Vorlauf 19 kommend den ersten Anschluss des ersten Umschaltventils 21.1 passiert und in zwei Kühlmittelströme aufgeteilt wird, die das erste Umschaltventil 21 über dessen zweiten Anschluss 21.2 und dessen vierten Anschluss 21.4 verlassen, um die beiden Kühlregister 15 parallel zu durchströmen. Die beiden Kühlmittelströme treten dann über den zweiten Anschluss 22.2 und den vierten Anschluss 22.4 des zweiten Umschaltventils 22 in dieses ein, werden wieder zu einem Kühlmittelstrom vereint, der über den dritten Anschluss 22.3 des zweiten Umschaltventils 22 in den Rücklauf 20 eintritt. Bei dieser Schaltung der beiden Umschaltventile 21, 22 strömt der Kühlmittelstrom demnach nicht durch die Ventilverbindungsleitung 23.

Im zweiten Betriebsmodus hingegen, wenn die Kühlregister 15 in Reihenschaltung durchströmbar sind, sind die beiden Umschaltventile 21, 22 derart geschaltet,
- dass im ersten Umschaltventil 21 dessen erster Anschluss 21.1 mit dessen viertem Anschluss 21.4 hydraulisch verbunden ist und dessen zweiter Anschluss 21.2 mit dessen drittem Anschluss 21.3 hydraulisch verbunden ist, und
- dass im zweiten Umschaltventil 22 dessen erster Anschluss 22.1 mit dessen viertem Anschluss 22.4 hydraulisch verbunden ist und dessen zweiter Anschluss 22.2 mit dessen drittem Anschluss 22.3 hydraulisch verbunden ist.

Der Kühlmittelstrom wird nun so gelenkt, dass er vom Vorlauf 19 kommend über den ersten Anschluss 21.1 des ersten Umschaltventils 21 in dieses eintritt, um es dann über dessen vierten Anschluss 21.4 zu verlassen. Der Kühlmittelstrom durchströmt ein erstes der beiden Kühlregister 15, passiert den vierten Anschluss 22.4 und den ersten Anschluss 22.1 des zweiten Umschaltventils 22, durchströmt die Ventilverbindungsleitung 23 und tritt dann über den dritten Anschluss 21.3 des ersten Umschaltventils 21 erneut in dieses ein. Er verlässt das erste Umschaltventil 21 über dessen zweiten Anschluss 21.2, durchströmt das zweite der beiden Kühlregister 15 und passiert den zweiten Anschluss 22.2 und den dritten Anschluss 22.3 des zweiten Umschaltventils 22, bevor er zum Rücklauf 20 gelangt.

## Patentansprüche

1. Verfahren zum Temperieren eines Rechenzentrums (R) unter Nutzung eines Kühlsystems (1),
welches einen dem Rechenzentrum (R) Wärme entziehenden Primär-Wärmetauscher (2) und einen Wärme an die Umgebung abgebenden, als Kühlmittel-Luft-Wärmetauscher ausgeführten Sekundär-Wärmetauscher (4) umfasst,
welcher ein Gehäuse (13), ein Gebläse (14) und zwei V-förmig angeordnete Kühlregister (15) aufweist,
wobei der Primär-Wärmetauscher (2) in einen Kühlmittel-Primärkreis (I) und der Sekundär-Wärmetauscher (4) in einen Kühlmittel-Sekundärkreis (II) eingebettet sind, zwischen welche ein einen Kältemittel-Verdichter (8) und eine Kältemittel-Expansionseinheit (9) aufweisender Kompressionskältemaschinenkreis (K) schaltbar ist, wobei weiterhin in einem ersten Betriebsmodus ein Wärmetransport vom Kühlmittel-Primärkreis (I) auf den Kühlmittel-Sekundärkreis (II) unter Zwischenschaltung des Kompressionskältemaschinenkreises (K) und in einem zweiten Betriebsmodus ein Wärmetransport vom Kühlmittel-Primärkreis (I) auf den Kühlmittel-Sekundärkreis (II) ohne Zwischenschaltung des Kompressionskältemaschinenkreises (K) erfolgt, **dadurch gekennzeichnet, dass**
die Kühlregister (15) des Sekundär-Wärmetauschers (4) in dem ersten Betriebsmodus in Parallelschaltung, im zweiten Betriebsmodus hingegen in Reihenschaltung durchströmt sind.

2. Verfahren nach Anspruch 1, **dadurch gekennzeichnet, dass** im zweiten Betriebsmodus der Kühlmittel-Primärkreis (I) und der Kühlmittel-Sekundärkreis (II) mittels schaltbarer Verbindungsleitungen (10, 11) hydraulisch miteinander verbunden sind.

3. Verfahren nach Anspruch 1, **dadurch gekennzeichnet, dass** im zweiten Betriebsmodus der Kühlmittel-Primärkreis (I) und der Kühlmittel-Sekundärkreis (II) über einen als Kühlmittel-Kühlmittel-Wärmetauscher ausgebildeten Koppel-Wärmetauscher (12) gekoppelt sind.

4. Verfahren nach Anspruch 1, **dadurch gekennzeichnet, dass** das Umschalten zwischen Parallelschaltung und Reihenschaltung der Kühlregister (15) des Sekundär-Wärmetauschers (4) mittels einer Ventil-Leitungseinheit (16) erfolgt, die innerhalb des Sekundär-Wärmetauschers (4) untergebracht ist.

5. Verfahren nach Anspruch 1, **dadurch gekennzeichnet, dass** die Auswahl eines Betriebsmodus durch den Abgleich eines oder mehrerer Mess- und/oder Sollwerte mit entsprechenden, in einer Steuerung hinterlegten Kennfeldern erfolgt.

6. Kühlsystem (1), geeignet zum Temperieren eines Rechenzentrums (R), welches einen Wärme einschleusenden Primär-Wärmetauscher (2) und einen Wärme ausschleusenden, als Kühlmittel-Luft-Wärmetauscher ausgeführten Sekundär-Wärmetauscher (4) umfasst, welcher ein Gehäuse (13), ein Gebläse (14) und zwei V-förmig angeordnete Kühlregister (15) aufweist, wobei der Primär-Wärmetauscher (2) in einen Kühlmittel-Primärkreis (I) und der Sekundär-Wärmetauscher (4) in einen Kühlmittel-Sekundärkreis (II) eingebettet sind, zwischen welche ein einen Kältemittel-Verdichter (8) und eine Kältemittel-Expansionseinheit (9) aufweisender Kompressionskältemaschinenkreis (K) schaltbar ist, wobei das Kühlsystem (1) in einem
ersten Betriebsmodus, in dem ein Wärmetransport vom Kühlmittel-Primärkreis (I) auf den Kühlmittel-Sekundärkreis (II) unter Zwischenschaltung des Kompressionskältemaschinenkreises (K) erfolgt,
und in einem zweiten Betriebsmodus, in dem ein Wärmetransport vom Kühlmittel-Primärkreis (I) auf den Kühlmittel-Sekundärkreis (II) ohne Zwischenschaltung des Kompressionskältemaschinenkreises (K) erfolgt, betreibbar ist, **dadurch gekennzeichnet, dass** die Kühlregister (15) des Sekundär-Wärmetauschers (4) in dem ersten Betriebsmodus in Parallelschaltung, im zweiten Betriebsmodus hingegen in Reihenschaltung durchströmbar sind.

7. Kühlsystem (1) nach Anspruch 6, **dadurch gekennzeichnet, dass** im zweiten Betriebsmodus der Kühlmittel-Primärkreis (I) und der Kühlmittel-Sekundärkreis (II) mittels schaltbarer Verbindungsleitungen (10, 11) hydraulisch miteinander verbunden sind.

8. Kühlsystem (1) nach Anspruch 6, **dadurch gekennzeichnet, dass** im zweiten Betriebsmodus der Kühlmittel-Primärkreis (I) und der Kühlmittel-Sekundärkreis (II) über einen als Kühlmittel-Kühlmittel-Wärmetauscher ausgebildeten Koppel-Wärmetauscher (12) gekoppelt sind.

9. Kühlsystem (1) nach Anspruch 6, **dadurch gekennzeichnet, dass** das Umschalten zwischen Parallelschaltung und Reihenschaltung der Kühlregister (15) des Sekundär-Wärmetauschers (4) mittels einer Ventil-Leitungseinheit (16) erfolgt, die innerhalb des Sekundär-Wärmetauschers (4) untergebracht ist.

10. Kühlsystem (1) nach Anspruch 6, **dadurch gekennzeichnet, dass** die Auswahl eines Betriebsmodus durch den Abgleich eines oder mehrerer Mess- und/oder Sollwerte mit entsprechenden, in einer Steuerung hinterlegten Kennfeldern erfolgt.

## Claims

1. A method for controlling the temperature of a computing centre (R) using a cooling system (1),
which comprises a primary heat exchanger (2), which extracts heat from the computing centre (R), and a secondary heat exchanger (4), which emits heat to the environment and is designed as a coolant-air heat exchanger,
which has a housing (13), a fan (14) and two cooling coils (15) arranged in a V-shaped manner,
the primary heat exchanger (2) being embedded into a primary coolant circuit (I) and the secondary heat exchanger (4) being embedded into a secondary coolant circuit (II), between which a compression refrigerator circuit (K) having a refrigerant compressor (8) and a refrigerant expansion unit (9) can be connected, heat transport furthermore taking place from the primary coolant circuit (I) to the secondary coolant circuit (II) in a first operating mode with the interposition of the compression refrigerator circuit (K) and heat transport taking place from the primary coolant circuit (I) to the secondary coolant circuit (II) in a second operating mode without interposition of the compression refrigerator circuit (K), **characterized in that**
the cooling coils (15) of the secondary heat exchanger (4) are flowed through in parallel in the first operating mode and in series by contrast in the second operating mode.

2. The method according to Claim 1, **characterized in that** in the second operating mode, the primary coolant circuit (I) and the secondary coolant circuit (II) are hydraulically connected to one another by means of switchable connecting lines (10, 11).

3. The method according to Claim 1, **characterized in that** in the second operating mode, the primary coolant circuit (I) and the secondary coolant circuit (II) are coupled by means of a coupling heat exchanger (12) which is designed as a coolant-coolant heat exchanger.

4. The method according to Claim 1, **characterized in that** the switch over between parallel connection and series connection of the cooling coils (15) of the secondary heat exchanger (4) takes place by means of a valve-line unit (16), which is accommodated inside the secondary heat exchanger (4).

5. The method according to Claim 1, **characterized in that** the selection of an operating mode takes place by matching one or more measured and/or desired values with corresponding characteristic maps stored in a control.

6. A cooling system (1), which is suitable for controlling the temperature of a computing centre (R) and which has a primary heat exchanger (2), which draws heat in, and a secondary heat exchanger (4), which is designed as a coolant-air heat exchanger and extracts heat, which has a housing (13), a fan (14) and two cooling coils (15) arranged in a V-shaped manner, the primary heat exchanger (2) being embedded into a primary coolant circuit (I) and the secondary heat exchanger (4) being embedded into a secondary coolant circuit (II), between which a compression refrigerator circuit (K) having a refrigerant compressor (8) and a refrigerant expansion unit (9) can be connected, it being possible to operate the cooling system (1) in a first operating mode, in which heat transport takes place from the primary coolant circuit (I) to the secondary coolant circuit (II) with the interposition of the compression refrigerator circuit (K), and in a second operating mode, in which heat transport takes place from the primary coolant circuit (I) to the secondary coolant circuit (II) without interposition of the compression refrigerator circuit (K), **characterized in that** the cooling cools (15) of the secondary heat exchanger (4) can be flowed through in parallel in the first operating mode and in series by contrast in the second operating mode.

7. The cooling system (1) according to Claim 6, **characterized in that** in the second operating mode, the primary coolant circuit (I) and the secondary coolant circuit (II) are hydraulically connected to one another by means of switchable connecting lines (10, 11).

8. The cooling system (1) according to Claim 6, **characterized in that** in the second operating mode, the primary coolant circuit (I) and the secondary coolant circuit (II) are coupled by means of a coupling heat exchanger (12) which is designed as a coolant-coolant heat exchanger.

9. The cooling system (1) according to Claim 6, **characterized in that** the switch over between parallel connection and series connection of the cooling coils (15) of the secondary heat exchanger (4) takes place by means of a valve-line unit (16), which is accommodated inside the secondary heat exchanger (4).

10. The cooling system (1) according to Claim 6, **characterized in that** the selection of an operating mode takes place by matching one or more measured and/or desired values with corresponding characteristic maps stored in a control.

## Revendications

1. Procédé, destiné à thermoréguler un centre informatique (R) en utilisant un système de refroidissement (1),
lequel comprend un échangeur thermique primaire (2) soutirant de la chaleur au centre informatique (R) et un échangeur thermique secondaire (4) restituant de la chaleur à l'environnement et réalisé sous la forme d'un échangeur thermique air/agent réfrigérant,
lequel comporte un boîtier (13), un ventilateur (14) et deux registres de refroidissement (15), placés en forme de V,
l'échangeur thermique primaire (2) étant incorporé dans un circuit primaire (I) d'agent réfrigérant et l'échangeur thermique secondaire (4) étant incorporé dans un circuit secondaire (II) d'agent réfrigérant, entre lesquels est commutable un compresseur (8) d'agent réfrigérant et un circuit (K) de réfrigérateur à compression de vapeur comportant une unité d'expansion (9) d'agent réfrigérant, par ailleurs dans un premier mode de fonctionnement, un transfert de chaleur s'effectuant du circuit primaire (I) d'agent réfrigérant sur le circuit secondaire (II) d'agent réfrigérant, sous interposition du circuit (K) de réfrigérateur à compression de vapeur et dans un deuxième mode de fonctionnement, un transfert de chaleur s'effectuant du circuit primaire (I) d'agent réfrigérant sur le circuit secondaire (II) d'agent réfrigérant, sans interposition du circuit (K) de réfrigérateur à compression de vapeur, **caractérisé en ce que**
les registres de refroidissement (15) de l'échangeur thermique secondaire (4) sont irrigués en connexion parallèle dans le premier mode de fonctionnement, inversement en connexion en série, dans le deuxième mode de fonctionnement.

2. Procédé selon la revendication 1, **caractérisé en ce que** dans le deuxième mode de fonctionnement, le circuit primaire (I) d'agent réfrigérant et le circuit secondaire (II) d'agent réfrigérant sont hydrauliquement reliés l'un à l'autre au moyen de conduits de liaison (10, 11) commutables.

3. Procédé selon la revendication 1, **caractérisé en ce que** dans le deuxième mode de fonctionnement, le circuit primaire (I) d'agent réfrigérant et le circuit secondaire (II) d'agent réfrigérant sont accouplés par l'intermédiaire d'un échangeur thermique de couplage (12), conçu sous la forme d'un échangeur thermique agent réfrigérant/agent réfrigérant.

4. Procédé selon la revendication 1, **caractérisé en ce que** le passage entre la connexion parallèle et la connexion en série des registres de refroidissement (15) de l'échangeur thermique secondaire (4) s'effectue au moyen d'une unité de ligne/soupape (16) qui est logée à l'intérieur de l'échangeur thermique secondaire (4).

5. Procédé selon la revendication 1, **caractérisé en ce que** la sélection d'un mode de fonctionnement s'effectue par une harmonisation d'une ou de plusieurs valeurs de mesure et/ou de consigne, avec des diagrammes caractéristiques correspondants, sauvegardés dans un système de commande.

6. Système de refroidissement (1), apte à thermoréguler un centre informatique (R), lequel comprend un échangeur thermique primaire (2) introduisant de la chaleur et un échangeur thermique secondaire (4) évacuant de la chaleur, réalisé sous la forme d'échangeur thermique air/agent réfrigérant, lequel comporte un boîtier (13), un ventilateur (14) et deux registres de refroidissement (15) placés en forme de V, l'échangeur thermique primaire (2) étant incorporé dans un circuit primaire (I) d'agent réfrigérant et l'échangeur thermique secondaire (4) étant incorporé dans un circuit secondaire (II) d'agent réfrigérant, entre lesquels est commutable un compresseur (8) d'agent réfrigérant et un circuit (K) de réfrigérateur à compression de vapeur comportant une unité d'expansion (9) d'agent réfrigérant, le système de refroidissement (1) étant utilisable dans un premier mode de fonctionnement, dans lequel un transfert de chaleur s'effectue du circuit primaire (I) d'agent réfrigérant sur le circuit secondaire (II) d'agent réfrigérant, sous interposition du circuit (K) de réfrigérateur à compression de vapeur, et dans un deuxième mode de fonctionnement, dans lequel un transfert de chaleur s'effectue du circuit primaire (I) d'agent réfrigérant sur le circuit secondaire (II) d'agent réfrigérant, sans interposition du circuit (K) de réfrigérateur à compression de vapeur, **caractérisé en ce que** les registres de refroidissement (15) de l'échangeur thermique secondaire (4) sont irrigables en connexion parallèle dans le premier mode de fonctionnement, inversement en connexion en série, dans le deuxième mode de fonctionnement.

7. Système de refroidissement (1) selon la revendication 6, **caractérisé en ce que** dans le deuxième mode de fonctionnement, le circuit primaire d'agent réfrigérant et le circuit secondaire (II) d'agent réfrigérant sont hydrauliquement reliés l'un à l'autre au moyen de conduits de liaison (10, 11) commutables.

8. Système de refroidissement (1) selon la revendication 6, **caractérisé en ce que** dans le deuxième mode de fonctionnement, le circuit primaire (I) d'agent réfrigérant et le circuit secondaire (II) d'agent réfrigérant sont accouplés par l'intermédiaire d'un échangeur thermique de couplage (12), conçu sous la forme d'un échangeur thermique agent réfrigérant/agent réfrigérant.

9. Système de refroidissement (1) selon la revendication 6, **caractérisé en ce que** le passage entre la connexion parallèle et la connexion en série des registres de refroidissement (15) de l'échangeur thermique secondaire (4) s'effectue au moyen d'une unité de ligne/soupape (16) qui est logée à l'intérieur de l'échangeur thermique secondaire (4).

10. Système de refroidissement (1) selon la revendication 6, **caractérisé en ce que** la sélection d'un mode de fonctionnement s'effectue par une harmonisation d'une ou de plusieurs valeurs de mesure et/ou de consigne, avec des diagrammes caractéristiques correspondants, sauvegardés dans un système de commande.
